# EUROPÄISCHE PATENTSCHRIFT

(11) **EP 3 837 558 B1**
(45) Veröffentlichungstag und Bekanntmachung des Hinweises auf die Patenterteilung: **13.07.2022**
(21) Anmeldenummer: 19753018.1
(22) Anmeldetag: 07.08.2019
(51) Int. Cl.: G01R 1/20, G01R 31/42, H02M 5/297, H02M 1/32, G01R 19/00

(54) **FREQUENZUMRICHTER**
FREQUENCY CONVERTER
VARIATEUR DE FRÉQUENCE

(30) Priorität: 13.08.2018 DE 102018213623
(43) Veröffentlichungstag der Anmeldung: 23.06.2021
(73) Patentinhaber: Lenze SE (Societas Europaea), 31855 Aerzen (DE)
(72) Erfinder: STAHEL, Robin, 8355 Aadorf (CH); BURGERMEISTER, Andreas, 8576 Mauren (CH)
(74) Vertreter: Patentanwälte Ruff, Wilhelm, Beier, Dauster & Partner mbB
(86) Internationale Anmeldenummer: PCT/EP2019/071271
(87) Internationale Veröffentlichungsnummer: WO 2020/035381

(56) Entgegenhaltungen:
- EP-A1- 2 200 141
- EP-B1- 2 200 141
- DE-A1-102016 222 754
- JP-A- 2000 194 456
- US-A1- 2009 132 188
- US-A1- 2015 372 594

## Beschreibung

Die Erfindung betrifft einen Frequenzumrichter.

Bei der so genannten Emittershunt-Strommessung zur Messung von Motorströmen, die bei Frequenzumrichtern Anwendung finden kann, ist ein Shunt-Widerstand in mindestens einem Brückenzweig des Frequenzumrichters angeordnet. Diesbezüglich sei auch auf die einschlägige Fachliteratur verwiesen.

Die DE 10 2016 222 754 A1 zeigt einen Frequenzumrichter nach dem Oberbegriff des Anspruchs 1.

Die US 2009/0132188 A1 zeigt eine Vorrichtung zum Laden und Entladen von Batterien mit einer Ladestrombestimmungsvorrichtung.

Die JP 2000 194456 A zeigt eine Batterieüberwachungseinrichtung basieren auf einer Ladestromüberwachung.

Die EP 2 200 141 A1 zeigt eine Schaltungsanordnung zum Schutz eines elektrischen Verbrauchers.

Die US 2015/0372594 A1 zeigt eine Schaltung, bei der ein Komparator-Eingang von einem Shunt-Widerstand für die Dauer eines Schaltübergangs getrennt wird. Die DE10046393 schlägt einen Hochpassfilter zum Detektieren eine Spannungsspitze in einem Messschunt eines Motortreibers vor und das anschließende sperren des Motortreibers.

Der Erfindung liegt die Aufgabe zugrunde, einen Frequenzumrichter zur Verfügung zu stellen, der eine einfache, zuverlässige und kostengünstige Emittershunt-Strommessung ermöglicht. Die Erfindung löst diese Aufgabe durch einen Frequenzumrichter nach Anspruch 1.

Der Frequenzumrichter weist herkömmlich mindestens einen Brückenzweig auf, wobei ein Shunt-Widerstand in dem Brückenzweig angeordnet ist, der insbesondere zur Motorstrommessung dienen kann. Der Frequenzumrichter kann insbesondere drei Brückenzweige aufweisen, wobei in mindestens zwei Brückenzweigen ein jeweiliger Shunt-Widerstand angeordnet ist. Insoweit sei auch auf die einschlägige Fachliteratur verwiesen.

Der Frequenzumrichter weist weiter eine Auswerteeinrichtung mit einem Eingangsanschluss auf, wobei die Auswerteeinrichtung dazu ausgebildet ist, ein an dem Eingangsanschluss anstehendes Messsignal, das von einer an dem Shunt-Widerstand abfallenden Spannung abhängig ist, zum Bestimmen einer Messgröße auszuwerten. Das Messsignal kann eine Spannung sein. Das Messsignal kann mit der an dem Shunt-Widerstand abfallenden Spannung identisch sein. Die Messgröße kann beispielsweise ein Motorstrom bzw. ein Strom in eine zugehörige Phase eines Elektromotors sein.

Der Frequenzumrichter weist weiter eine Spannungsspitzen-Unterdrückungseinrichtung auf, die dazu ausgebildet ist, beim Auftreten einer Spannungsspitze an dem Shunt-Widerstand den Eingangsanschluss der Auswerteeinrichtung kurzzuschließen. Die Spannungsspitzen-Unterdrückungseinrichtung kann dazu ausgebildet sein, beim Auftreten der Spannungsspitze an dem Shunt-Widerstand den Eingangsanschluss der Auswerteeinrichtung für eine vorbestimmte Zeitdauer kurzzuschließen oder so lange kurzzuschließen, bis sich ein vorgegebenes Spannungsniveau eingestellt hat. Die vorgegebene Zeitdauer kann beispielsweise zwischen 2 µs bis 10 µs betragen.

Die Spannungsspitzen-Unterdrückungseinrichtung weist mindestens ein Schaltmittel auf, das zwischen den Eingangsanschluss der Auswerteeinrichtung eingeschleift ist und das mittels eines Ansteuersignals angesteuert ist, wobei das Schaltmittel in Abhängigkeit von einem Zustand des Ansteuersignals den Eingangsanschluss der Auswerteeinrichtung kurzschließt oder nicht kurzschließt. Beispielsweise kann das Schaltmittel in Form eines pnp-Transistors und eines parallel geschalteten npn-Transistors verkörpert sein, um Ableitströme bzw. Kurzschlussströme in zwei Richtungen zu ermöglichen. Alternativ zu den Bipolartransistoren kann selbstverständlich beispielsweise auch ein MOSFET als Schaltmittel verwendet werden.

Die Spannungsspitzen-Unterdrückungseinrichtung weist ein Hochpassfilter auf, das in Abhängigkeit von der an dem Shunt-Widerstand abfallenden Spannung das Ansteuersignal erzeugt. Das Hochpassfilter ist derart zu dimensionieren, dass bei den typischen Pegeln der Spannungsspitzen, den typischen Anstiegszeiten der Spannungsspitzen und/oder den typischen Dauern der Spannungsspitzen das Ansteuersignal derart erzeugt wird, dass die Spannungsspitzen wirksam durch Kurzschließen unterdrückt bzw. zeitlich ausgeblendet werden.

Gemäß einer Ausführungsform weist die Spannungsspitzen-Unterdrückungseinrichtung eine monostabile Kippstufe auf, die in Abhängigkeit von der an dem Shunt-Widerstand abfallenden Spannung das Ansteuersignal erzeugt. Beispielsweise kann die monostabile Kippstufe durch die Spannungsspitze getriggert werden und das Ansteuersignal derart erzeugen, dass der Eingangsanschluss der Auswerteeinrichtung für eine vorgegebene Zeitdauer kurzgeschlossen wird. Die vorgegebene Zeitdauer kann beispielsweise zwischen 2 µs bis 10 µs betragen.

Gemäß einer Ausführungsform ist die Spannungsspitzen-Unterdrückungseinrichtung dazu ausgebildet, den Eingangsanschluss der Auswerteeinrichtung kurzzuschließen, wenn die Spannungsspitze bzw. ein zugrunde liegender Spannungsverlauf an dem Shunt-Widerstand folgende Eigenschaften aufweist: die Spannung an dem Shunt-Widerstand weist einen Pegel auf, der größer als 1V ist, und/oder eine Anstiegszeit der Spannung an dem Shunt-Widerstand auf einen vorgegebenen Pegel, beispielsweise 1 V, ist kleiner als 100 ns, und/oder eine Dauer, während der die Spannung an dem Shunt-Widerstand größer als ein Schwellenwert ist, beispielsweise 1 V, ist kleiner als 500 ns.

Gemäß einer Ausführungsform weist der Brückenzweig ein erstes ansteuerbares Schaltmittel und ein zweites ansteuerbares Schaltmittel auf, wobei das erste ansteuerbare Schaltmittel, das zweite ansteuerbare Schaltmittel und der Shunt-Widerstand in Reihe zwischen einen ersten Zwischenkreispol und einen zweiten Zwischenkreispol eingeschleift sind, wobei zwischen dem ersten Zwischenkreispol und dem zweiten Zwischenkreispol eine Zwischenkreisspannung ansteht.

Bei der Emittershunt-Strommessung werden die Motorströme jeweils nur an den unteren Schaltmitteln der jeweiligen Brückenzweige gemessen. Dadurch ist der Messstrom durch den Shunt-Widerstand gepulst. Durch die resultierende Induktivität des Shunt-Widerstands und von zugehörigen Leiterbahnen entsteht während des Einschaltvorgangs eine Spannungsspitze bzw. ein Spannungspeak. Diese Spannungsspitze kann nicht mittels eines einfachen Tiefpassfilters entfernt werden, da die Spannungsspitze nicht symmetrisch ist. Ein weiterer Grund ist, dass auch sehr schmale Impulse gemessen werden müssen, beispielsweise mit einer Dauer von < 10 µs bei einer zugrunde liegenden Pulsweitenmodulation mit 16 kHz.

Am Beispiel eines Frequenzumrichters für 400 VAC und einer typischen Flankensteilheit von 100 ns (entspricht 5.6 kV/µs) muss das Schaltmittel bzw. der IGBT eines jeweiligen Brückenzweigs bei langen Motorkabeln (> 20m) sehr hohe Schaltströme treiben. Dadurch fällt über dem Shunt-Widerstand eine hohe Spannung ab, die durch dessen Induktivität nochmals deutlich erhöht wird. Eine Amplitude einer Spannungsspitze beim Einschalten des unteren Schaltmittels des Brückenzweigs ist wesentlicher größer als ein Pegel des eigentlichen Messsignals. Dies verursacht starke Verzerrungen und Schwingungen des Messsignals. Typisch ist der Messwert erst nach ca. 10 µs stabil. Derartige Einschwingzeiten sind bei Schaltfrequenzen einer Pulsweitenmodulation von größer als 6 kHz nicht tolerierbar.

Erfindungsgemäß wird nun die durch das Einschalten des unteren Schaltmittels des Brückenzweigs verursachte Spannungsspitze zeitlich ausgeblendet. Hierzu wird ein Schaltmittel verwendet, beispielsweise in Form eines oder mehrerer Transistoren, das das auszuwertende Signal bzw. Messsignal während einer vorgegebenen Dauer kurzschließt. Ein Ansteuersignal des Schaltmittels kann beispielsweise mittels eines Hochpassfilters erzeugt werden. Sobald beispielsweise über dem Shunt-Widerstand (inkl. Leiterbahn) eine Spannungsspitze von ca. 1 V auftritt, schließt das Schaltmittel das Messsignal kurz. Ist die durch die Induktivität verursachte Spannungsspitze abgeklungen, wird das Schaltmittel geöffnet, so dass das Messsignal an der Auswerteeinrichtung ansteht.

Erfindungsgemäß werden folglich durch die Induktivität verursachte Störimpulse zeitlich ausgeblendet. Dadurch ergeben sich folgende Vorteile:
- höhere Strommessgenauigkeit (bei bestehenden Schaltungen)
- niederohmiger Shunt-Widerstand möglich (weniger Verlustleistung)
- Shunt-Widerstand kann ohne Kühlung als SMD- Bauteil auf einer Platine angeordnet werden (bei Frequenzumrichtern bis mind. 22 kW/400 V)
- kostengünstig, da Shunt-Widerstände anstelle von Stromwandlern verwendet werden können
- reduzierte Störempfindlichkeit
- Emittershunt-Strommessung auch mit zukünftigen Technologien möglich (sehr schnelle Leistungshalbleiter).

Die Erfindung wird nachfolgend unter Bezugnahme auf die Zeichnung detailliert beschrieben. Hierbei zeigt:

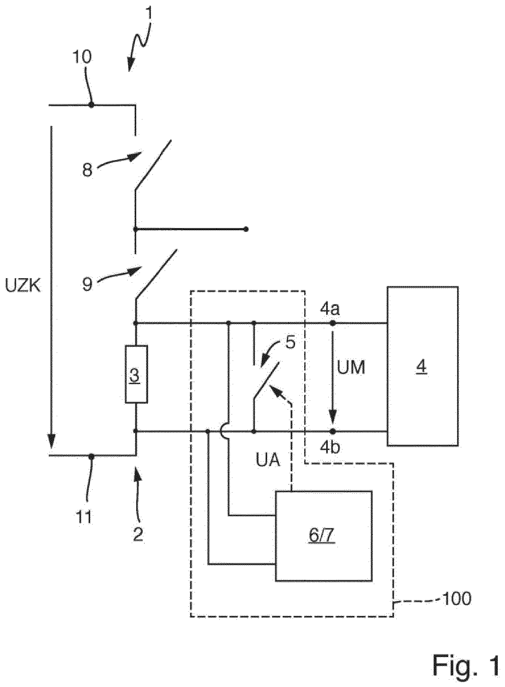

- Fig.1: ein hoch schematisches Blockschaltbild eines erfindungsgemäßen Frequenzumrichters.

Fig. 1 zeigt ein hoch schematisches Blockschaltbild eines erfindungsgemäßen Frequenzumrichters 1.

Der Frequenzumrichter 1 weist insgesamt drei Brückenzweige 2 auf, wobei exemplarisch lediglich ein einziger Brückenzweig 2 dargestellt ist. In dem Brückenzweig 2 sind herkömmlich zwei ansteuerbare Schaltmittel 8 und 9, beispielsweise in Form von IGBTs, sowie ein Shunt-Widerstand 3 angeordnet, wobei der Brückenzweig 2 mit einer Zwischenkreisspannung UZK beaufschlagt ist. Ein Verbindungspunkt der beiden ansteuerbaren Schaltmittel 8 und 9 bildet herkömmlich einen Phasenanschluss für einen nicht dargestellten Elektromotor. Das erste ansteuerbare Schaltmittel 8, das zweite ansteuerbare Schaltmittel 9 und der Shunt-Widerstand 3 sind in Reihe zwischen einen ersten Zwischenkreispol 10 und einen zweiten Zwischenkreispol 11 eingeschleift, wobei die Zwischenkreisspannung UZK zwischen den beiden Zwischenkreispolen 10 und 11 ansteht. Insoweit sei auch auf die einschlägige Fachliteratur verwiesen.

Der Frequenzumrichter 1 weist weiter eine Auswerteeinrichtung 4 mit einem Eingangsanschluss mit zwei Eingangsanschlusspolen 4a und 4b auf, wobei die Auswerteeinrichtung 4 dazu ausgebildet ist, ein an dem Eingangsanschluss bzw. den Eingangsanschlusspolen 4a und 4b anstehendes Messsignal in Form einer Messspannung UM zum Bestimmen einer Messgröße in Form eines Motorstroms bzw. Motorstrommesswerts auszuwerten. Die Messspannung UM entspricht der am Shunt-Widerstand 3 abfallenden Spannung. Die Auswerteeinrichtung 4 kann beispielsweise als Mikroprozessor ausgebildet sein.

Der Frequenzumrichter 1 weist weiter eine Spannungsspitzen-Unterdrückungseinrichtung 100 aufweisend Komponenten 5, 6, 7 auf, wobei die Spannungsspitzen-Unterdrückungseinrichtung 100 bzw. deren Komponenten 5, 6, 7 dazu ausgebildet ist/sind, beim Auftreten einer Spannungsspitze an dem Shunt-Widerstand 3, d.h. einer Spannungsspitze der Messspannung UM, den Eingangsanschluss bzw. die Eingangsanschlusspole 4a, 4b der Auswerteeinrichtung 4 kurzzuschließen, um die Spannungsspitze auszublenden.

Die Spannungsspitzen-Unterdrückungseinrichtung 100 weist ein ansteuerbares Schaltmittel 5 auf, das zwischen den Eingangsanschluss bzw. die Eingangsanschlusspole 4a und 4b der Auswerteeinrichtung 4 eingeschleift ist und das mittels eines Ansteuersignals UA angesteuert ist. Das ansteuerbare Schaltmittel 5 kann beispielsweise durch zwei Transistoren gebildet sein, beispielsweise einen npn- und einen parallel geschalteten pnp-Transistor. Das Schaltmittel 5 schließt in Abhängigkeit von einem Zustand des Ansteuersignals UA den Eingangsanschluss bzw. die Eingangsanschlusspole 4a und 4b der Auswerteeinrichtung 4 kurz oder nicht.

Die Spannungsspitzen-Unterdrückungseinrichtung 100 weist weiter beispielsweise ein Hochpassfilter 6 auf, das in Abhängigkeit von der an dem Shunt-Widerstand 3 abfallenden Spannung bzw. einem zeitlichen Verlauf der Messspannung UM das Ansteuersignal UA derart erzeugt, dass bei einer Spannungsspitze der Messspannung UM das Schaltmittel 5 für ca. 2 µs geschlossen wird und anschließend wieder geöffnet wird.

Alternativ oder zusätzlich zum Hochpassfilter 6 kann die Spannungsspitzen-Unterdrückungseinrichtung 100 eine monostabile Kippstufe 7 aufweisen, die in Abhängigkeit von der an dem Shunt-Widerstand 3 abfallenden Spannung bzw. der Messspannung UM das Ansteuersignal UA geeignet erzeugt.

Eine Spannungsspitze an dem Shunt-Widerstand 3 bzw. der Messspannung UM genügt typisch folgender Definition: die Spannungsspitze weist einen Spannungspegel auf, der größer als 1V ist, und/oder die Spannungsspitze weist eine Anstiegszeit bis auf 1 V von weniger als 100 ns auf, und/oder die Spannungsspitze weist eine Dauer mit einem Spannungspegel von typisch größer als 1 V von weniger als 500 ns auf.

## Patentansprüche

1. Frequenzumrichter (1), aufweisend:
- mindestens einen Brückenzweig (2), wobei ein Shunt-Widerstand (3) in dem mindestens einen Brückenzweig (2) angeordnet ist, und
- eine Auswerteeinrichtung (4) mit einem Eingangsanschluss (4a, 4b), wobei die Auswerteeinrichtung (4) dazu ausgebildet ist, ein an dem Eingangsanschluss (4a, 4b) anstehendes Messsignal (UM), das von einer an dem Shunt-Widerstand (3) abfallenden Spannung abhängig ist, zum Bestimmen einer Messgröße auszuwerten,
**dadurch gekennzeichnet, dass**
- der Frequenzumrichter (1) eine Spannungsspitzen-Unterdrückungseinrichtung (100) aufweist, die dazu ausgebildet ist, beim Auftreten einer Spannungsspitze an dem Shunt-Widerstand (3) den Eingangsanschluss (4a, 4b) der Auswerteeinrichtung (4) kurzzuschließen,
- wobei die Spannungsspitzen-Unterdrückungseinrichtung (100) aufweist:
- mindestens ein Schaltmittel (5), das zwischen den Eingangsanschluss (4a, 4b) der Auswerteeinrichtung (4) eingeschleift ist und das mittels eines Ansteuersignals (UA) angesteuert ist, wobei das Schaltmittel (5) in Abhängigkeit von einem Zustand des Ansteuersignals (UA) den Eingangsanschluss (4a, 4b) der Auswerteeinrichtung (4) kurzschließt, und
- ein Hochpassfilter (6), das in Abhängigkeit von der an dem Shunt-Widerstand (3) abfallenden Spannung das Ansteuersignal (UA) erzeugt.

2. Frequenzumrichter (1) nach Anspruch 1, **dadurch gekennzeichnet, dass**
- die Spannungsspitzen-Unterdrückungseinrichtung (100) aufweist:
- eine monostabile Kippstufe (7), die in Abhängigkeit von der an dem Shunt-Widerstand (3) abfallenden Spannung das Ansteuersignal (UA) erzeugt.

3. Frequenzumrichter (1) nach einem der vorhergehenden Ansprüche, **dadurch gekennzeichnet, dass**
- die Spannungsspitzen-Unterdrückungseinrichtung (100) dazu ausgebildet ist, den Eingangsanschluss (4a, 4b) der Auswerteeinrichtung (4) kurzzuschließen, wenn die Spannungsspitze an dem Shunt-Widerstand (3) folgende Eigenschaften aufweist:
- einen Pegel, der größer als 1V ist, und/oder
- eine Anstiegszeit von weniger als 100 ns, und/oder
- eine Dauer von weniger als 500 ns.

4. Frequenzumrichter (1) nach einem der vorhergehenden Ansprüche, **dadurch gekennzeichnet, dass**
- der mindestens eine Brückenzweig (2) ein erstes ansteuerbares Schaltmittel (8) und ein zweites ansteuerbares Schaltmittel (9) aufweist, wobei das erste ansteuerbare Schaltmittel (8), das zweite ansteuerbare Schaltmittel (9) und der Shunt-Widerstand (3) in Reihe zwischen einen ersten Zwischenkreispol (10) und einen zweiten Zwischenkreispol (11) eingeschleift sind.

## Claims

1. Frequency converter (1) having:
- at least one bridge arm (2), wherein a shunt resistor (3) is arranged in the at least one bridge arm (2), and
- an evaluation device (4) having an input connection (4a, 4b), wherein the evaluation device (4) is designed to evaluate a measurement signal (UM), which is present at the input connection (4a, 4b) and is dependent on a voltage dropped across the shunt resistor (3), in order to determine a measurement variable,
**characterized in that**
- the frequency converter (1) has a voltage peak suppression device (100) which is designed to short-circuit the input connection (4a, 4b) of the evaluation device (4) if a voltage peak occurs at the shunt resistor (3),
- wherein the voltage peak suppression device (100) has:
- at least one switching means (5) which is looped in between the input connection (4a, 4b) of the evaluation device (4) and is controlled by means of a control signal (UA), wherein the switching means (5) short-circuits the input connection (4a, 4b) of the evaluation device (4) on the basis of a state of the control signal (UA), and
- a high-pass filter (6) which generates the control signal (UA) on the basis of the voltage dropped across the shunt resistor (3).

2. Frequency converter (1) according to Claim 1, **characterized in that**
- the voltage peak suppression device (100) has:
- a monostable flip-flop (7) which generates the control signal (UA) on the basis of the voltage dropped across the shunt resistor (3).

3. Frequency converter (1) according to either of the preceding claims, **characterized in that**
- the voltage peak suppression device (100) is designed to short-circuit the input connection (4a, 4b) of the evaluation device (4) if the voltage peak at the shunt resistor (3) has the following properties:
- a level which is greater than 1 V, and/or
- a rise time of less than 100 ns, and/or
- a duration of less than 500 ns.

4. Frequency converter (1) according to one of the preceding claims, **characterized in that**
- the at least one bridge arm (2) has a first controllable switching means (8) and a second controllable switching means (9), wherein the first controllable switching means (8), the second controllable switching means (9) and the shunt resistor (3) are looped in in series between a first intermediate circuit pole (10) and a second intermediate circuit pole (11).

## Revendications

1. Convertisseur de fréquence (1), comprenant :
- au moins une branche de pont (2), une résistance de dérivation (3) étant disposée dans l'au moins une branche de pont (2), et
- un dispositif d'évaluation (4) comprenant une borne d'entrée (4a, 4b), le dispositif d'évaluation (4) étant conçu pour évaluer un signal de mesure (UM), qui est présent au niveau de la borne d'entrée (4a, 4b) et qui dépend de la chute de tension aux bornes de la résistance de dérivation (3), afin de déterminer une grandeur de mesure,
**caractérisé en ce que**
- le convertisseur de fréquence (1) comporte un dispositif de suppression de crête de tension (100) qui est conçu pour court-circuiter la borne d'entrée (4a, 4b) du dispositif d'évaluation (4) lorsqu'une crête de tension se produit sur la résistance de dérivation (3),
- le dispositif de suppression de crête de tension (100) comportant :
- au moins un moyen de commutation (5) qui est bouclé au milieu de la borne d'entrée (4a, 4b) du dispositif d'évaluation (4) et qui est commandé au moyen d'un signal de commande (UA), le moyen de commutation (5) court-circuitant la connexion d'entrée (4a, 4b) du dispositif d'évaluation (4) en fonction d'un état du signal de commande (UA) et
- un filtre passe-haut (6) qui génère le signal de commande (UA) en fonction de la chute de tension aux bornes de la résistance de dérivation (3).

2. Convertisseur de fréquence (1) selon la revendication 1, **caractérisé en ce que**
- le dispositif de suppression de crêtes de tension (100) comporte :
- un multivibrateur monostable (7) qui génère le signal de commande (UA) en fonction de la chute de tension aux bornes de la résistance de dérivation (3) .

3. Convertisseur de fréquence (1) selon l'une des revendications précédentes, **caractérisé en ce que**
- le dispositif de suppression de crêtes de tension (100) est conçu pour court-circuiter la borne d'entrée (4a, 4b) du dispositif d'évaluation (4) lorsque la crête de tension sur la résistance de dérivation (3) présente les propriétés suivantes :
- un niveau supérieur à 1V, et/ou
- un temps de montée inférieur à 100 ns, et/ou
- une durée inférieure à 500 ns.

4. Convertisseur de fréquence (1) selon l'une des revendications précédentes, **caractérisé en ce que**
- l'au moins une branche de pont (2) comporte un premier moyen de commutation commandable (8) et un deuxième moyen de commutation commandable (9), le premier moyen de commutation commandable (8), le deuxième moyen de commutation commandable (9) et la résistance de dérivation (3) étant bouclés en série entre un premier pôle de circuit intermédiaire (10) et un deuxième pôle de circuit intermédiaire (11).
